# EUROPEAN PATENT APPLICATION

(11) **EP 1 253 432 A2**
(43) Date of publication of application: **30.10.2002**
(21) Application number: 02100414.8
(22) Date of filing: 25.04.2002
(51) Int. Cl.: G01R 31/3185

(54) **Power reduction in module-based scan testing**

(30) Priority: 26.04.2001 US 286632 P
(71) Applicant: Texas Instruments Incorporated, Dallas, Texas 75251 (US)
(72) Inventor: SAXENA, Jayashree, 75082, Richardson (US); BUTLER, Kenneth M., 75082-3829, Richardson (US); JAIN, Atul K., 75240, Dallas (US); FRYARS, Anthony, NN6 9ED, Northampton (GB); HETHERINGTON, Graham G., MK44, Bedfordshire (GB)
(74) Representative: Holt, Michael

(57) **Abstract**

A circuit and method for reducing the power consumed by module-based scan testing. In one embodiment constant data is provided to inputs, such as 33, of scan chains not used in testing, such as 32. Another embodiment is a method whereby transitions in a subset of scan chains, such as 32, are minimized through the use of constant input data.

## Description

This invention relates to power reduction in module-based scan testing using constant input data.

FIG. 1 shows a scan test circuit.

FIG. 2 shows a circuit for power reduction in module-based scan testing.

Scan test is a design technique that increases the testability of a primary circuit by replacing all or some of its storage elements by scan storage elements. The scan storage elements apply input stimulus to the primary circuit and then measure the response of the primary circuit to that input stimulus. Faults contained in the primary circuit are detected through this process.

A reduction in power usage during test is realized through the use of constant input data in module-based scan testing. Several aspects of this invention are described below with reference to example applications for illustration. It should be understood that numerous specific details, relationships, and methods are set forth to provide a full understanding of the invention. One skilled in the relevant art, however, will readily recognize that the invention can be practiced without one or more of the specific details, or with other methods, etc. In other instances, well-known structures or operations are not shown in detail to avoid obscuring the invention.

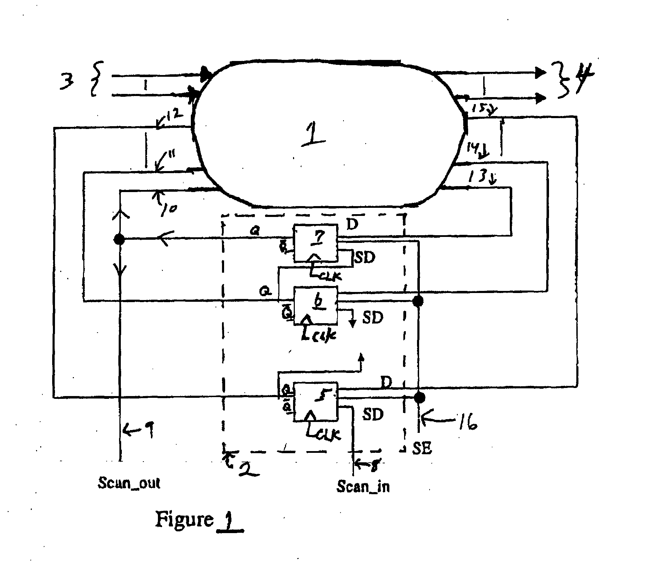

Referring to the drawings, FIG. 1 depicts a circuit for conducting a scan test of the circuitry of an integrated circuit device. The circuitry related to the primary device is commonly called 'core logic'. Because of the large size of integrated circuits, it is often partitioned into sub-circuits. As shown in FIG. 1, the sub-circuit core logic, 1, is coupled to a scan chain, 2, (described in detail next). Sub-circuit core logic 1 has primary inputs, 3, and primary outputs, 4. The primary inputs 3 and primary outputs 4 are used by the sub-circuit core logic 1 during the normal operation of the primary device.

A scan chain 2 performs the scan testing of sub-circuit core logic 1. The example scan chain 2 shown in FIG. 1 is comprised of memory elements, 5, 6, 7, which are multiplexed scan flip-flops. These flip-flops are connected as a shift register to form the scan chain 2. During normal operation the flip-flops capture values from (on lines 13, 14, 15) and provide inputs to (on lines 10, 11, 12) the combinational logic of the sub-circuit core logic 1.

During the rising edge of the clock, when the Scan Enable ("SE") pin equals '0', the flip-flops capture data from the Data ("D") input. When SE equals '1' the flip-flop captures data from the Scan Data ("SD") input. Within the scan chain 2, the Q output of a flip-flop is connected to the SD input of the next flip-flop in the chain. In this example application, the output that is the compliment of Q is not used. However, it is within the scope of the invention to use the compliment of Q output to perform the scan function with equal effectiveness.

The test pattern is sent to the scan chain 2 through the Scan-in input, 8, connected to the SD input of the first flip-flop 5.
The Q output of the last flip-flop 7 in the shift register is connected to Scan_out 9. (The Q output of the last flip-flop 7 is also connected through line 10 to the sub-circuit core logic 1, for use during normal circuit operation.)

When scan testing is performed on sub-circuit core logic 1 the tester (not shown) sends a test pattern on line 8 to the scan chain 2. The SE input, 16, is set to a logic level 1 by the tester during this procedure in order to load the test pattern onto the flip-flops through their SD inputs. The tester pulses the clock as many times as the length of the scan chain to load the full test pattern into the scan chain 2.

Once the test pattern has been shifted into the scan chain, the tester sends signals to the primary inputs 3 of the sub-circuit core logic 1. The tester then applies a capture clock and sets SE, line 16, to a logic level 0 in order to capture the responsive output values of the sub-circuit core logic into the flip-flops of scan chain 2. Next, the tester drives SE to a logic level 1 and shifts into the scan chain 2 the next test pattern while simultaneously receiving the contents of the scan chain via Scan_out 9 for analysis and fault detection.

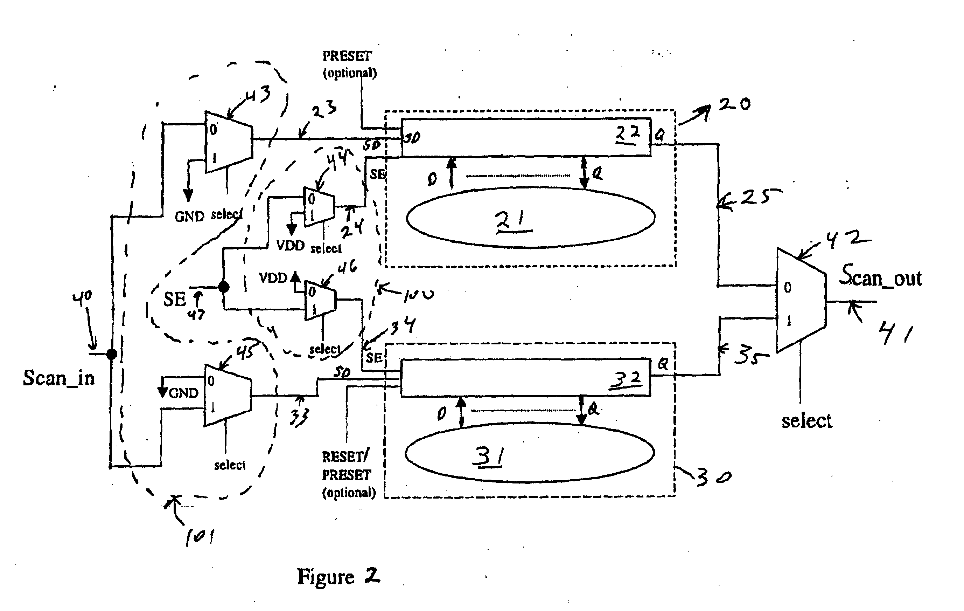

As shown in FIG. 2, there are situations where scan pins are shared between scan chains belonging to different cores (or "modules"), such as 20, 30. In the example application shown in FIG. 2, circuitry 21 is the sub-circuit core logic of core 20; while circuitry 31 is the sub-circuit core logic of core 30. In the example application, scan chain 22 is similar to scan chain 2 of FIG. 1 and belongs to core 20; while scan chain 32 is also similar to scan chain 2 of FIG. 1 and it belongs to core 30. When testing is performed in a modular manner it is often referred to as "module-based scan testing".

The configuration shown in FIG. 2 is used in situations where scan pins are shared between scan chains belonging to different cores/modules. This configuration facilitates the use of a subset of the scan chains at any given point in time, resulting in reduced power consumption during the test process. This test procedure is often used in core-based designs where scan testing of one core can be performed followed by the scan testing of another core in the same design.

Referring to Fig. 2, multiplexers and tie logic are added to the scan inputs of all chains in order to provide constant data to scan inputs of chains not used in testing. The result is that power consumption is reduced in those scan chains not used in testing because the constant data input prevents the power consuming signal transitions within the scan chain. In the example application of this invention, shown in FIG. 2, Scan_in 40 is the scan input signal for both scan chains 22 and 32. Scan_out 41 is the scan output signal for both scan chains and is driven by either scan chain 22 or 32 based on the value of the "select" signal of multiplexer 42.

The example application also shows the use of an optional asynchronous RESET or PRESET for scan chains 22 and 32. The RESET feature would be used in situations where the logic level of the test pattern sent to unused scan chains is a '0'. Conversely, the PRESET feature would be used in situations where the logic level of the test pattern sent to unused scan chains is a '1'. If a RESET or PRESET is not used, then the first test pattern flushes out the pre-existing data in the scan chain and initializes the scan chain for subsequent receipt of the constant data input pattern. In order to avoid capturing arbitrary data from the sub-circuit core logic (thus increasing power consumption by unused scan chains), the unused scan chains are kept in scan shift mode by holding the SE pin, 47, at a logic 1 level during the time that the constant data is provided to the unused scan chains.

During an example test operation, if select is a logic level 0 then the RESET is triggered on scan chain 32 to initialize its' flip-flops to the '0' state. This prepares scan chain 32 to operate at a reduced power level while receiving constant '0' data. The constant '0' data is received by scan chain 32 on SD input 33 because select on multiplexer 45 is '0'. Furthermore, the select on multiplexer 46 being '0' causes SE input 34 to hold at a logic level '1'.

With select at level '0', multiplexer 43 transfers the test pattern data from the tester, on Scan_in 40, to the SD input, 23, of scan chain 22. Multiplexer 44, with select at '0', pulls the SE input, 24, to a '0' value. This facilitates the capture by the scan chain flip-flops of the response of the sub-circuit logic 21 to the test pattern stimulus. The responsive data is then shifted out of the scan chain 22 on line 25, and sent to the tester for analysis on Scan_out 41 since select is at '0' on multiplexer 42.

When select is '1' then sub-circuit 31 is tested in the manner just described while the unused scan chain 22 operates at a reduced power level. If a PRESET operation is used instead of a RESET operation then a logic level '1' should be sent to the unused scan chain by multiplexers 43 or 45. As mentioned previously, if a RESET or PRESET function is not used, then the power consumption of unused scan chains can still be realized by using the first scan operation to scan all '0's or '1's into the unused chains to initialize them before sending the constant data signal of the same value (while holding the SE pin at '1').

This invention is also applicable to situations where the test procedure described in FIG. 2 is expanded to numerous chains per core/module. In situations where numerous scan chains are used, the multiplexers (such as 43 and 45) associated with Scan_in 40 would have inputs corresponding to each scan chain (such as 22 and 32) and select between the scan chains with a multi-bit select (for example, 1...sel [log 2ⁿ] ). Similarly the multiplexers associated with SE (such as 44 and 46) would need to be able to select between multiple scan chains. This configuration would allow for one or more scan chains to test sub-circuit core logic while the remaining, unused, scan chains received constant data.

Clearly, this invention could be realized with many different circuit or logic configurations. For example, the scan circuitry could be created using transistor gates, AND/OR structures, pass transistor logic, switches, PLA's, ASIC's, DSP's, etc.

Furthermore, modifications of this invention could be used for different test configurations. For example, if the scan chains do not share the Scan_in pin then the constant data value sent to the scan chains would be provided directly by the tester. In this situation, if the SE input is shared, then the logical function contained in the FIG. 2 dashed box 100 is needed.

Conversely, if the scan chains do not share the SE pin then the tester performs the scan enable function. In this situation, if the Scan_in is shared, then the logical function contained in the FIG. 2 dashed box 101 is needed.

While various embodiments of the present invention have been described above, it should be understood that they have been presented by way of example only, and not limitation. Numerous changes to the disclosed embodiments can be made in accordance with the disclosure herein without departing from the spirit or scope of the invention. Thus, the breadth and scope of the present invention should not be limited by any of the above described embodiments. Rather, the scope of the invention should be defined in accordance with the following claims and their equivalents.

## Claims

1. A method of scan testing an integrated circuit comprising:
testing said integrated circuit using at least two scan chains; whereby transitions in a subset of said scan chains are minimized through the use of constant input data.

2. A method of scan testing an integrated circuit having multiple cores comprising wherein the method of claim 1 is applied to each of said cores.

3. A method of scan testing as claimed in any preceding claim wherein the subject includes a scan chain which is not being used for testing.

4. A method as claimed in any preceding claim comprising:
performing a reset of all of said scan chains that will not be used for the next test pattern;
providing a constant data level throughout said test pattern to said scan chains that will not be used for the next test pattern.

5. The method of any preceding claim wherein said constant data level is a logic level 0.

6. A method as claimed in any of claims 1 to 4 comprising:
performing a preset of all of said scan chains that will not be used for the next test pattern;
providing a constant data level throughout said test pattern to said scan chains that will not be used for the next test pattern.

7. The method of claim 6 wherein said constant data level is a logic level 1.

8. An integrated circuit comprising:
means for reducing transitions in scan test chains not used in test.

9. An integrated circuit as claimed in claim 8 comprising:
means for providing constant data to inputs of scan test chains not used in testing.

10. An integrated circuit as claimed in claim 8 or claim 9 comprising:
scanable flip-flops forming at least two scan chains; multiplexers and tie logic coupled to said scan chains; whereby said multiplexers and tie logic provides constant data levels to scan inputs of said scan chains not used in testing.

11. An integrated circuit as claimed in claim 10 wherein comprising:
said scan chains have asynchronous reset capability.

12. The circuit of any of claims 8 to 11 wherein said constant data levels are a logic level 0.

13. An integrated circuit as claimed in claim 10 wherein comprising:
said scan chains have asynchronous preset capability.

14. The circuit of claim 13 wherein said constant data levels are a logic level 1.
